(19) **Europäisches Patentamt European Patent Office Office européen des brevets**

(11) **EP 4 625 795 A1**

(12) **EUROPEAN PATENT APPLICATION**

(43) Date of publication:
01.10.2025 Bulletin 2025/40

(21) Application number: 24201855.4

(22) Date of filing: 23.09.2024

(51) International Patent Classification (IPC):
$H02M\ 1/32^{(2007.01)}$     $H02M\ 7/487^{(2007.01)}$

(52) Cooperative Patent Classification (CPC):
H02M 7/487; H02M 1/32

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 25.03.2024 CN 202410346686

(71) Applicant: Sungrow Power Supply Co., Ltd.
Hefei, Anhui 230088 (CN)

(72) Inventors:
• CAO, Jinhu
  Hefei 230088 (CN)
• ZHANG, Bing
  Hefei 230088 (CN)
• HU, Fanyu
  Hefei 230088 (CN)
• LI, Wei
  Hefei 230088 (CN)
• FENG, Jigui
  Hefei 230088 (CN)

(74) Representative: Zacco Norway AS
P.O. Box 488 Skøyen
0213 Oslo (NO)

(54) **POWER CONVERSION SYSTEM, POWER CONVERTER AND METHOD FOR CONTROLLING POWER CONVERTER**

(57)    This application provides a power conversion system, a power converter and a method for controlling the power converter, which relates to the technical field of power electronics. The method includes detecting a current of the main circuit, and applying multiple PWM modifying strategies to power conversion topologies of three phases if overcurrent occurs in the main circuit. In addition, instead of uniformly modifying the power conversion topologies of the three phases in technical solutions according to the conventional technology, among the PWM modifying strategies in the present disclosure, a voltage at an AC side of a power conversion topology of an overcurrent phase has a largest change range and a current at the AC side has a fastest speed of decrease. Thereby, the current at the AC side of the power conversion topology of the overcurrent phase can rapidly decrease, avoiding switchover of PWM control logics frequently triggered due to the current at the AC side being in the vicinity of an overcurrent point. Finally, after the overcurrent is removed, the power conversion topologies of the three phases are restored to be in the original PWM control manner, thereby adapting to outside disturbance.

Figure 6

EP 4 625 795 A1

**Description**

**FIELD**

The present disclosure relates to the technical field of power electronics, and in particular to a power conversion system, a power converter and a method for controlling the power converter.

**BACKGROUND**

Pulse width modulation (PWM) control is an important control means in the technical field of power electronics, for controlling power electronics circuit topologies, such as a DC/DC circuit or a DC/AC circuit. PWM control is essential for application of power converters in the field of power electronics. Generally, a PWM control manner is applied in the normal operation of power converters. In practice, the operation of a power converter is inevitably subject to the impact of outside factors, such as fluctuations due to a switchover of a load or a power grid failure (such as short-circuit grounding or inter-phase short-circuit). As being connected to a power grid, the power converter is affected necessarily, and a PWM control manner for a stable operation condition is not suitable for the power converter. As a consequence, an instantaneous current at an AC side of the power converter is excessive, resulting in grid-off triggered by protection or even a control failure.

To solve the above problem, in the conventional technology, when an abnormal signal is detected, a PWM control manner for the power converter is timely modified to adapt to outside disturbance, to ensure the safe operation of the power converter. However, for power conversion circuit topologies of three phases, this solution in the conventional technology may lead to frequent switching between normal logic and abnormal logic in a PWM control manner for an overcurrent phase.

**SUMMARY**

In view of the above, a power conversion system, a power converter and a method for controlling the power converter are provided according to the present disclosure, to solve the problem of frequently triggering wave-by-wave current limiting in an overcurrent phase according to the conventional technology.

In order to achieve the above objective, the following technical solutions are provided according to the present disclosure.

In a first aspect of the present disclosure, a method for controlling a power converter is provided, where a main circuit of the power converter includes power conversion topologies of three phases, each of the power conversion topologies is a multi-level topology, and the method includes:

detecting a current of the main circuit;

applying multiple PWM modifying strategies to the power conversion topologies of the three phases if overcurrent occurs in the main circuit, where among the multiple PWM modifying strategies, a change range of a voltage at an AC side of a power conversion topology of an overcurrent phase is greater than a change range of a voltage at an AC side of a power conversion topology of a non-overcurrent phase, and a decrease speed of a current at the AC side of the power conversion topology of the overcurrent phase is greater than a decrease speed of a current at the AC side of the power conversion topology of the non-overcurrent phase; and

restoring, after the overcurrent is removed, the power conversion topologies of the three phases to be in an original PWM control manner.

In an embodiment, the applying multiple PWM modifying strategies to the power conversion topologies of the three phases includes:

controlling the voltage at the AC side of the power conversion topology of the overcurrent phase to change from a current level to a reverse level after passing through a zero level; and

controlling the voltage at the AC side of the power conversion topology of the non-overcurrent phase to change from a current level to the zero level.

In an embodiment, the controlling the voltage at the AC side of the power conversion topology of the overcurrent phase to change from a current level to a reverse level after passing through a zero level includes:

turning off a non-freewheeling switching transistor in the power conversion topology of the overcurrent phase; and

turning off a freewheeling switching transistor in the power conversion topology of the overcurrent phase if a first preset delay expires, where the freewheeling switching transistor is a switching transistor forming a zero-level path in the power conversion topology of the overcurrent phase, and the non-freewheeling switching transistor is a switching transistor in the power conversion topology of the overcurrent phase other than the freewheeling switching transistor.

In an embodiment, the controlling the voltage at the AC side of the power conversion topology of the non-overcurrent phase to change from a current level to the zero level includes:

turning off a non-freewheeling switching transistor in the power conversion topology of the non-overcurrent phase, and maintaining an original control signal for a freewheeling switching transistor in the power conversion topology of the non-overcurrent phase, where the freewheeling switching transistor is a switching transistor forming a zero-level path in the power conversion topology of the non-overcurrent phase, and the non-freewheeling switching transistor is a switching transistor in the power conversion topology of the non-overcurrent phase other than the freewheeling switching transistor.

In an embodiment, the restoring the power conversion topologies of the three phases to be in an original PWM control manner includes:

controlling the voltage at the AC side of the power conversion topology of the overcurrent phase to be a zero level; and

restoring voltages at AC sides of the power conversion topologies of the three phases to respective original levels if a second preset delay expires.

In an embodiment, the controlling the voltage at the AC side of the power conversion topology of the overcurrent phase to be a zero level includes:

restoring a control signal for a freewheeling switching transistor in the power conversion topology of the overcurrent phase to an original control signal, where the freewheeling switching transistor is a switching transistor forming a zero-level path in the power conversion topology of the overcurrent phase.

In an embodiment, the restoring voltages at AC sides of the power conversion topologies of the three phases to respective original levels includes:

restoring control signals for non-freewheeling switching transistors in the power conversion topologies of the three phases to respective original control signals, where the non-freewheeling switching transistors are switching transistor in the power conversion topologies of the three phases other than freewheeling switching transistors, and the freewheeling switching transistors are switching transistors forming a zero-level path in the power conversion topologies.

In an embodiment, the second preset delay is equal to or different from the first preset delay.

In an embodiment, the restoring after the overcurrent is removed, the power conversion topologies of the three phases to be in an original PWM control manner further includes:

restoring the power conversion topologies of the three phases to be in the original PWM control manner if a third preset delay expires.

In a second aspect of the present disclosure, a power converter is provided, which includes a main circuit and a controller, where

the main circuit includes power conversion topologies of three phases, DC sides of the power conversion topologies of the three phases are connected in parallel to a DC bus, and AC sides of the power conversion topologies of the three phases serve as an AC side of the main circuit,

each of the power conversion topologies is a multi-level topology,

the main circuit is controlled by the controller, and

the controller is configured to perform the method for controlling a power converter in the first aspect described above.

In an embodiment, the multi-level topology is one of the following topologies: an ANPC topology with three levels or more than three levels, an NPC topology with three levels or more than three levels, or a flying capacitor topology with three levels or more than three levels.

In an embodiment, the main circuit further includes at least one preceding-stage conversion circuit, where the at least one preceding-stage conversion circuit is connected to the DC bus and is controlled by the controller.

In an embodiment, the at least one preceding-stage conversion circuit is a DC/DC conversion circuit or an AC/DC conversion circuit.

In a third aspect of the present disclosure, a power conversion system is provided. The power conversion system includes a power supply and the power converter in the second aspect described above,
where the power supply is connected to at least one of a power grid or a load through the power converter.

In the method for controlling a power converter according to the present disclosure, a current of the main circuit is detected, and multiple PWM modifying strategies are applied to the power conversion topologies of the three phases. In addition, instead of uniformly modifying the power conversion topologies of the three phases in technical solutions according to the conventional technology, among the PWM modifying strategies in the present disclosure, a voltage at the AC side of the power conversion topology of the overcurrent phase has a largest change range and a current at the AC side has a fastest speed of decrease. Thereby, the current at the AC side of the power conversion topology of the overcurrent phase can rapidly decrease, avoiding switchover of PWM control logics frequently triggered due to the current at the AC side being in the vicinity of an overcurrent point. Finally, after the overcurrent is removed, the power conversion topologies of the three phases are restored to be in the original PWM control manner, thereby adapting to outside disturbance.

## BRIEF DESCRIPTION OF THE DRAWINGS

In order to more clearly illustrate technical solutions in embodiments of the present disclosure or in the conventional technology, the drawings to be used in the description of the embodiments or the conventional technology are briefly described below. Apparently, the drawings in the following description show only some embodiments of the present disclosure, and other drawings may be obtained by those skilled in the art from the drawings without any creative work.

Figure 1 is a schematic structural diagram of a three-level ANPC topology according to an embodiment of the present disclosure;

Figure 2 is a diagram of waveforms of control signals for a three-level ANPC topology according to an embodiment of the present disclosure;

Figure 3 is a schematic structural diagram of a three-level NPC topology according to an embodiment of the present disclosure;

Figure 4 is a schematic structural diagram of a five-level ANPC topology according to an embodiment of the present disclosure;

Figure 5 is a schematic structural diagram of a power converter according to an embodiment of the present disclosure;

Figure 6 is a flowchart of a method for controlling a power converter according to an embodiment of the present disclosure;

Figure 7 is a diagram of waveforms of currents at AC sides of power conversion topologies of three phases for inversion according to an embodiment of the present disclosure;

Figure 8 is a diagram of a current path in a case that a voltage at an AC side of a three-level ANPC topology is a positive level during a positive half cycle of a grid voltage according to an embodiment of the present disclosure;

Figure 9 is a diagram of a current path in a case that a voltage at an AC side of a three-level ANPC topology is a zero level during a positive half cycle of a grid voltage according to an embodiment of the present disclosure;

Figure 10 is a diagram of a current path in a case that a voltage at an AC side of a three-level ANPC topology is a negative level during a positive half cycle of a grid voltage according to an embodiment of the present disclosure;

Figure 11 is a diagram of a current path in a case that a voltage at an AC side of a three-level ANPC topology is a negative level during a negative half cycle of a grid voltage according to an embodiment of the present disclosure;

Figure 12 is a diagram of a current path in a case that a voltage at an AC side of a three-level ANPC topology is a zero level during a negative half cycle of a grid voltage according to an embodiment of the present disclosure;

Figure 13 is a diagram of a current path in a case that a voltage at an AC side of a three-level ANPC topology is a positive level during a negative half cycle of a grid voltage according to an embodiment of the present disclosure;

Figure 14 is a diagram of a current path in a case that a voltage at an AC side of a five-level ANPC topology is a maximum positive level during a positive half cycle of a grid voltage according to an embodiment of the present disclosure;

Figure 15 is a diagram of a current path in a case that a voltage at an AC side of a five-level ANPC topology is a zero level during a positive half cycle of a grid voltage according to an embodiment of the present disclosure;

Figure 16 is a diagram of a current path in a case that a voltage at an AC side of a five-level ANPC topology is a minimum negative level during a positive half cycle of a grid voltage according to an embodiment of the present disclosure;

Figure 17 is a diagram of a current path in a case that a voltage at an AC side of a five-level ANPC topology is a minimum negative level during a negative half cycle of a grid voltage according to an embodiment of the present disclosure;

Figure 18 is a diagram of a current path in a case that a voltage at an AC side of a five-level ANPC topology is a zero level during a negative half cycle of a grid voltage according to an embodiment of the present disclosure;

Figure 19 is a diagram of a current path in a case that a voltage at an AC side of a five-level ANPC topology is a maximum positive level during a negative half cycle of a grid voltage according to an embodiment of the present disclosure;

Figure 20 is a diagram of waveforms of control signals for a three-level ANPC topology in a normal condition according to an embodiment of the present disclosure;

Figure 21 is a diagram of waveforms of control signals for a three-level ANPC topology which is a power conversion topology of an overcurrent phase according to an embodiment of the present disclosure;

Figure 22 is a diagram of waveforms of control signals for a three-level ANPC topology which is a power conversion topology of a non-overcurrent phase according to an embodiment of the present disclosure; and

Figure 23 is a diagram of waveforms of control signals for a power conversion topology if overcurrent occurs according to an embodiment of the present disclosure.

## DETAILED DESCRIPTION

The technical solutions in the embodiments of the present disclosure are described clearly and completely in conjunction with the drawings in the embodiments of the present disclosure hereinafter. It is apparent that the described embodiments are only some rather than all embodiments of the present disclosure. All other embodiments obtained by those skilled in the art based on the embodiments of the present disclosure without any creative work fall within the protection scope of the present disclosure.

In the present disclosure, terms of "include", "comprise" or any other variants are intended to be non-exclusive. Therefore, a process, method, article or device including a series of elements includes not only the elements but also other elements that are not enumerated, or further includes the elements inherent for the process, method, article or device. Unless expressively limited otherwise, the statement "comprising (including) one... " does not exclude existence of other similar elements in the process, method, article or device.

A multi-level topology refers to a topology having three or more levels for inversion or rectification, such as an active neutral point clamped (ANPC) topology with various levels, a neutral point clamped (NPC) topology with various levels or a flying capacitor topology with various levels.

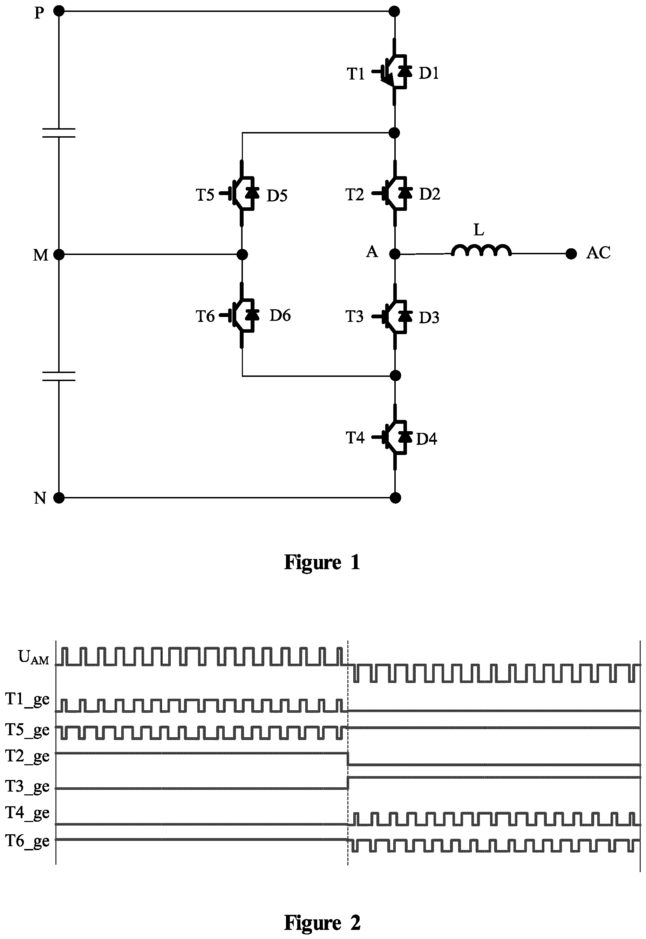

Figure 1 is a common multi-level topology applied in a power converter: a three-level ANPC topology, which includes six switching transistors T1 to T6. A switching transistor T1 connected to a positive electrode P of a DC side of the topology and a switching transistor T4 connected to a negative electrode N of the DC side of the topology are both outer switching transistors. Switching transistors T2 and T3 connected to an AC side A of the topology are both inner switching transistors. Switching transistors T5 and T6 connected to a middle point M of the DC side of the topology are both clamping switching transistors. D1 to D6 represent anti-parallel diodes for respective switching transistors. A driving manner for realizing an inverting function of the three-level ANPC topology is shown in Figure 2, where T1_ge to T6_ge represent control signals for the respective switching transistors, and $U_{AM}$ represents a voltage at the AC side of the three-level ANPC topology. In a case that the outer switching transistor T1 is turned on, the voltage $U_{AM}$ at the AC side of the three-level ANPC topology is a positive level, and in a case that the outer switching transistor T4 is turned on, the voltage UAM at the AC side of the three-level ANPC topology is a negative level. The inner switching transistors T2 and T3 and the clamping switching transistors T5 and T6 are all in a freewheeling circuit of the three-level ANPC topology, and are switching transistors forming a zero-level path in this topology, which therefore, may be referred to as freewheeling switching transistors. The other switching transistors T1 and T4 may be referred to as non-freewheeling switching transistors.

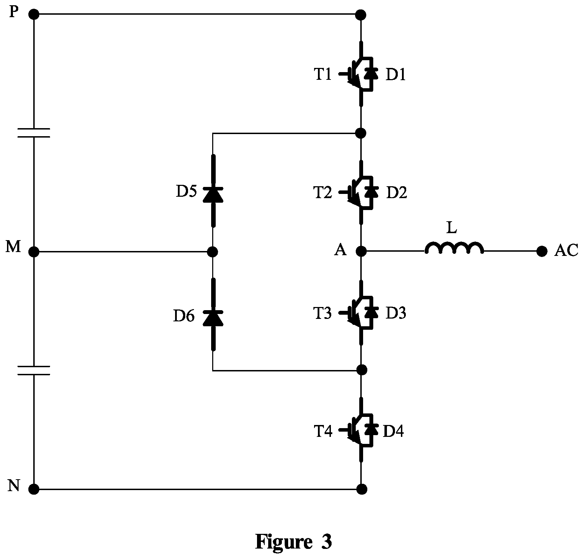

Figure 3 is another multi-level topology applied in a power converter: a three-level NPC topology, which differs from the three-level ANPC topology in that the three-level NPC topology is provided with clamping diodes D5 and D6 at corresponding positions instead of including the clamping switching transistors T5 and T6. Thus, the three-level NPC topology includes two non-freewheeling switching transistors T1 and T4 and two freewheeling switching transistors T2 and T3.

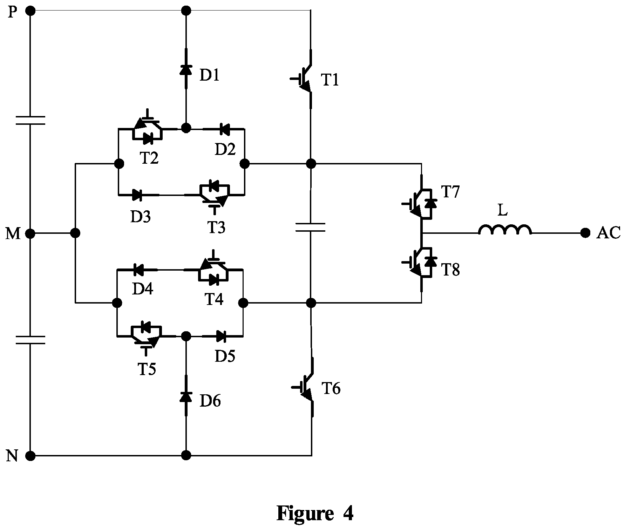

Figure 4 shows a five-level ANPC topology, which includes switching transistors T1 to T8 and diodes D1 to D6. The switching transistors are two non-freewheeling switching transistors T1 and T6, and six freewheeling switching transistors T2, T3, T4, T5, T7 and T8. Structures of other multi-level topologies are not enumerated herein.

Description is made based on inversion of the three-level ANPC topology hereinafter for example.

A current iL at an AC side of the three-level ANPC topology, i.e., a current on a filtering inductor L connected to the AC side, is calculated by the following equation:

$$i_L = \int_0^{t_{on}} (U_{AM} - U_{AC})\ dt \qquad (1)$$

Where, $t_{on}$ represents a duration for which the non-freewheeling switching transistor T1 or T4 is on in an effective inversion process, i.e., a pulse width of PWM driving, $U_{AM}$ represents a voltage at the AC side of the three-level ANPC topology, i.e., a bridge arm voltage of the AC side A with respect to the middle point M at the DC side of the three-level ANPC topology. $U_{AC}$ represents a voltage at a power grid side connected to the three-level ANPC topology through the filtering inductor L, which may be abbreviated as a grid voltage.

With reference to equation (1), when the current iL at the AC side increases, the duration $t_{on}$ for which the non-freewheeling switching transistor is on is shortened, or a terminal voltage $(U_{AM}-U_{AC})$ of the filtering inductor L of the power converter is reduced, in order to reduce the current iL. For reducing the terminal voltage $(U_{AM}-U_{AC})$ of the filtering inductor L of the power converter, the grid voltage $U_{AC}$ is an external variable of the power converter and is not under control, and therefore, the terminal voltage $(U_{AM}-U_{AC})$ of the filtering inductor L of the power converter may be reduced by reducing the voltage $U_{AM}$ at the AC side, thereby reducing the current at the AC side of the power converter.

For a power converter with power conversion topologies of three phases, in the conventional technology, voltages at AC sides of power conversion topologies of three phases are uniformly modified, to change terminal voltages of filtering inductors of the three phases in the power converter and prevent currents at the AC sides of the three phases from increasing. However, a PWM control strategy which does not distinguish an overcurrent phase from a non-overcurrent phase may cause PWM control of the overcurrent phase to frequent switching between normal logic and abnormal logic, such as frequently triggering wave-by-wave current limiting especially in a process of low/zero voltage ride-through.

In view of this, a method for controlling a power converter is provided according to the present disclosure, to solve the problem of frequently triggering wave-by-wave current limiting in an overcurrent phase according to the conventional technology.

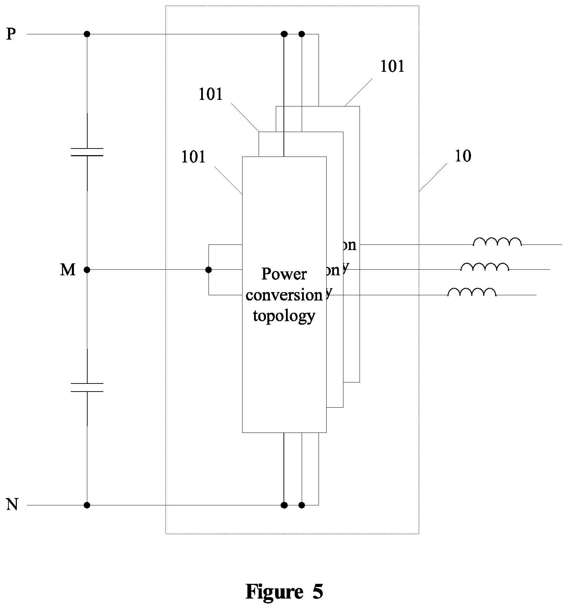

A main circuit of the power converter includes the power conversion topologies of three phases. As shown in Figure 5, DC sides of the power conversion topologies 101 of the three phases are connected in parallel, and AC sides of the power conversion topologies 101 of the three phases serve as an AC side of the main circuit 10. The power conversion topologies 101 of the three phases may be implemented by the three-level ANPC topology shown in Figure 1, the three-level NPC topology shown in Figure 3, or the five-level ANPC topology shown in Figure 4, which may depend on actual application scenarios and is not limited herein.

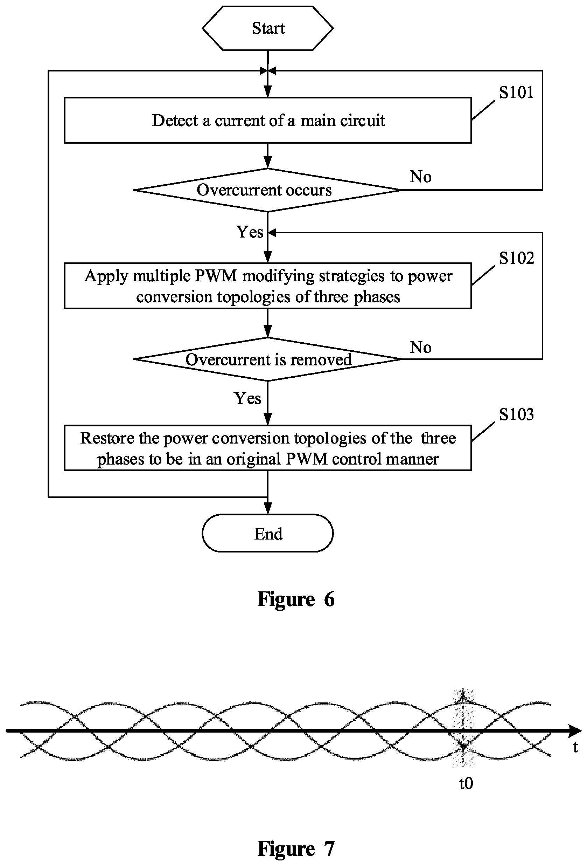

With reference to Figure 6, the method for controlling a power converter includes the following steps S101 to S103.

In step S101, a current of the main circuit is detected.

In practice, after a current at the AC side of the main circuit is detected, it is determined whether overcurrent occurs in the main circuit by hardware comparison or by a detection module in a controller of the power converter, and an abnormal signal is generated if overcurrent occurs in the main circuit.

When obtaining the abnormal signal, the controller determines that overcurrent occurs in the main circuit, and modifies a PWM logic of the main circuit in step S102 and changes action time of each switching transistor and a current path at the AC side, in order to reduce the current at the AC side.

In step S102, multiple PWM modifying strategies are applied to the power conversion topologies of the three phases.

The current at the AC side of the power converter has a waveform of a sine/cosine signal with a fixed frequency and fixed amplitude. Therefore, the occurrence of overcurrent is related to a phase. The overcurrent easily occurs at or near a peak value of the signal due to influence of an external voltage, while in such case, the overcurrent is unlikely to occur at the other phases due to a small current. In addition, overcurrent is generally unlikely to occur simultaneously in currents of the three phases due to a phase difference between the currents of the three phases. As shown in Figure 7, currents at AC sides of the power conversion topologies of three phases are abnormal at a peak value of one phase at a time instant t0. Since the abnormal current at the AC side of this phase occurs at the peak value, an abnormal amplitude of the current of this phase exceeds a safe range. This phase is an overcurrent phase, and leads to the generation of the above-mentioned abnormal signal. Since a sum of the currents of the three phases is zero, currents of the other two phases are also abnormal, and abnormal currents of the other two phases at respective phase positions at this time each are within the safe range, and thus these two phases are non-overcurrent phases.

In practice, among the PWM modifying strategies, a voltage at the AC side of the power conversion topology of the overcurrent phase is set to have a largest change range. For example, the voltage at the AC side of the power conversion topology of the overcurrent phase is controlled to change from a positive level to a negative level, while a voltage at the AC side of the power conversion topology of the non-overcurrent phase is controlled to change from a positive level to a zero level. In this case, the current at the AC side of the power conversion topology of the overcurrent phase has the fastest speed of decrease, thereby rapidly suppressing the occurrence of overcurrent.

The implementation in which the voltage at the AC side of the power conversion topology of the overcurrent phase has the largest change range is not limited to the above-described example. Other implementations in which the current at the AC side of the power conversion topology of the overcurrent phase has the fastest speed of decrease to suppress the occurrence of overcurrent also fall within the protection scope of the present disclosure.

After the overcurrent is removed, for example, after the abnormal signal disappears or resets, step S103 is performed.

In step S103, the power conversion topologies of the three phases are restored to be in an original PWM control manner.

The original PWM control manner is a PWM control manner applied to the power conversion topologies of the three phases in the main circuit before the overcurrent occurs, for which reference may be made to the conventional technology and therefore no detailed descriptions are made.

In the method for controlling a power converter according to this embodiment, if overcurrent occurs in the main circuit, a PWM modifying strategy is applied to the power conversion topology of each phase based on an overcurrent characteristic of the phase, instead of uniformly modifying the power conversion topologies of the three phases in technical solutions according to the conventional technology. In addition, among the multiple PWM modifying strategies in the present disclosure, the voltage at the AC side of the power conversion topology of the overcurrent phase has a largest change range and the current at the AC side has a fastest speed of decrease. Thereby, the current at the AC side of the power conversion topology of the overcurrent phase can rapidly decrease, avoiding switchover of PWM control logics, such as frequently triggering wave-by-wave current limiting due to the current at the AC side being in the vicinity of an overcurrent point. Finally, after the overcurrent is removed, the power conversion topologies of the three phases are restored to be in the original PWM control manner, thereby adapting to outside disturbance. In this way, the problem of overcurrent caused by the influence of outside disturbance on the power converter can be effectively solved, ensuring stable operation of the power converter.

Based on the above embodiment, in an embodiment, some examples for the specific implementation of step S102 in the above method for controlling a power converter are given. For example, step S102 may include the following steps (1) and (2).

In step (1), the voltage at the AC side of the power conversion topology of the overcurrent phase is controlled to change from a current level to a reverse level after passing through a zero level.

The following description is made taking a three-level ANPC topology operating in a positive half cycle of a grid voltage.

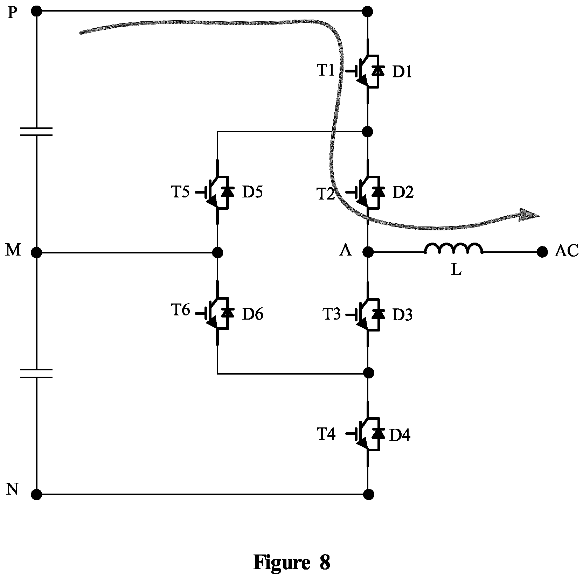

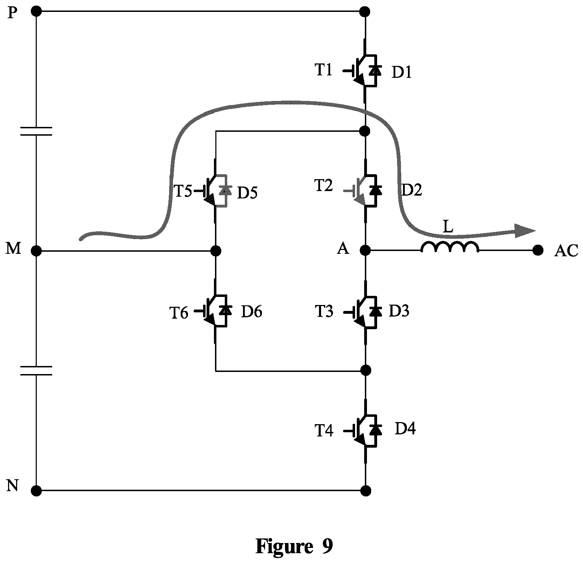

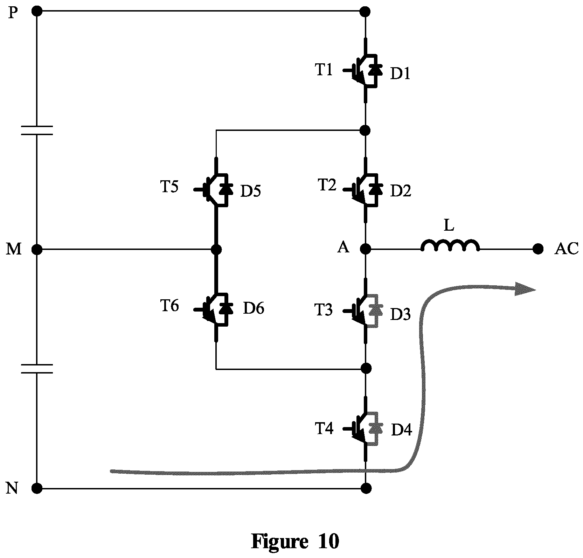

After obtaining the abnormal signal, the controller modifies a PWM control manner of the power conversion topology of the overcurrent phase, so that a current path of the topology sequentially transits from the arrowed curve in Figure 8 to the arrowed curve shown in Figure 9, and further to the arrowed curve shown in Figure 10. Accordingly, a terminal voltage ($U_{AP}$-$U_{AC}$) of the filtering inductor L changes from ($U_{AP}$-$U_{AC}$) to ($U_{AM}$-$U_{AC}$), and further to ($U_{AN}$-$U_{AC}$), where $U_{AP}$ represents a voltage at a point A if the AC side A is connected to a positive electrode P of the DC side in the three-level ANPC topology, and $U_{AN}$ represents a voltage at the point A if the AC side A is connected to a negative electrode N of the DC side in the three-level ANPC topology. That is, the voltage at the AC side of the power conversion topology of the overcurrent phase changes from a positive level (or referred to as +1 level), i.e., a positive voltage $U_{PM}$ of a bus of the power converter, to a zero level (or referred to as 0 level), i.e., a voltage $U_M$ at the middle point M of the bus of the power converter, and further to a negative level (or referred to as -1 level), i.e., a negative voltage $U_{MN}$ of the bus of the power converter. A level at a bridge arm terminal (i.e., the point A) of the filtering inductor L transits from the positive level to the negative level, and the current iL at the AC side of the power conversion topology of the overcurrent phase rapidly decreases.

In step (2), a voltage at an AC side of a power conversion topology of the non-overcurrent phase is controlled to change from a current level to the zero level.

After obtaining the abnormal signal, the controller modifies a PWM control manner of the power conversion topology of the non-overcurrent phase, so that a current path of the topology sequentially transits from the arrowed curve in Figure 8 to the arrowed curve shown in Figure 9. Accordingly, the terminal voltage of the filtering inductor L changes from $(U_{AP}-U_{AC})$ to $(U_{AM}-U_{AC})$. That is, the voltage at the AC side of the power conversion topology of the non-overcurrent phase changes from a positive level, i.e., the positive voltage $U_{PM}$ of the bus of the power converter, to a zero level, i.e., the voltage $U_M$ at the middle point M of the bus of the power converter. The level at the bridge arm terminal (i.e., the point A) of the filtering inductor L transits from the positive level to the zero level, and the current iL at the AC side of the power conversion topology of the non-overcurrent phase stops increasing and starts to decrease.

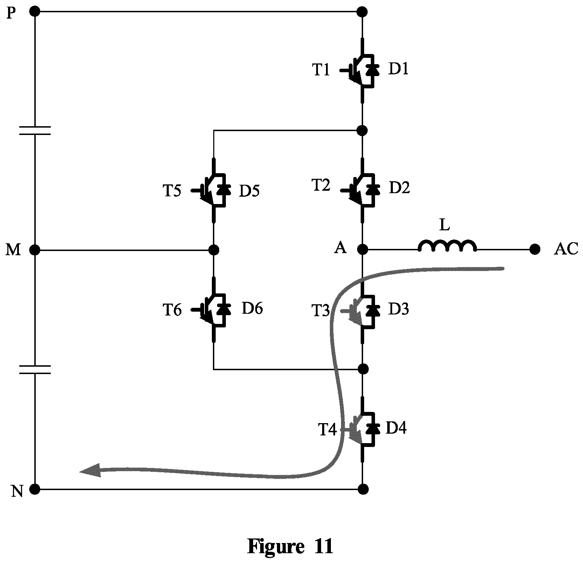

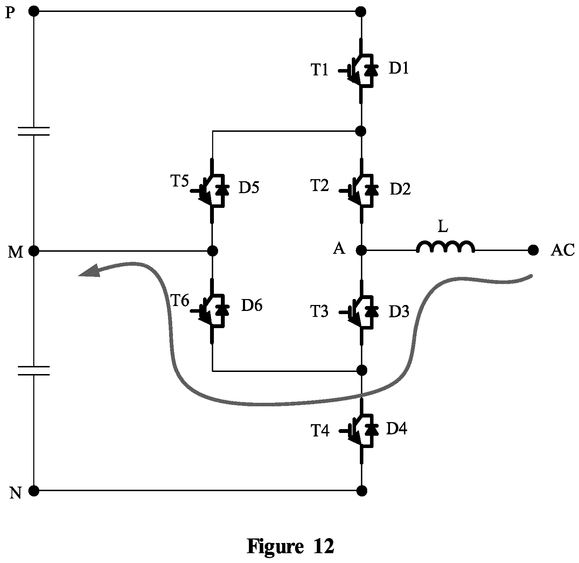

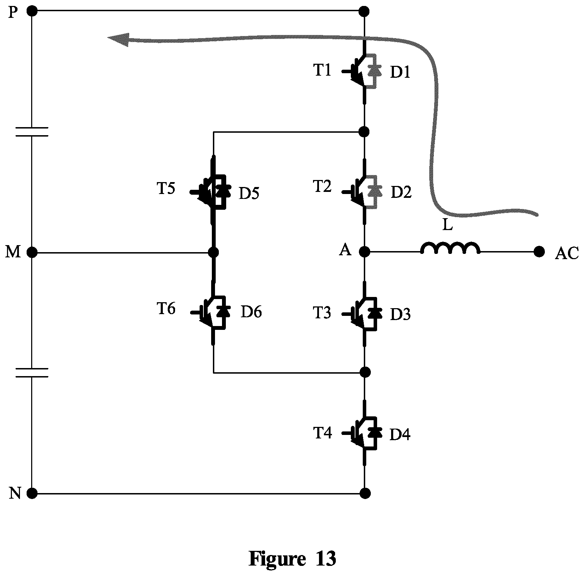

Reference may be made to Figures 11 to 13 for the case that the three-level ANPC topology operates in a negative half cycle of the grid voltage. The current path in the power conversion topology of the overcurrent phase is controlled to sequentially transit from the arrowed curve in Figure 11 to the arrowed curve shown in Figure 12, and further to the arrowed curve shown in Figure 13. The current path in the power conversion topology of the non-overcurrent phase is controlled to transit from the arrowed curve in Figure 11 to the arrowed curve shown in Figure 12. No more detailed description thereof is further made.

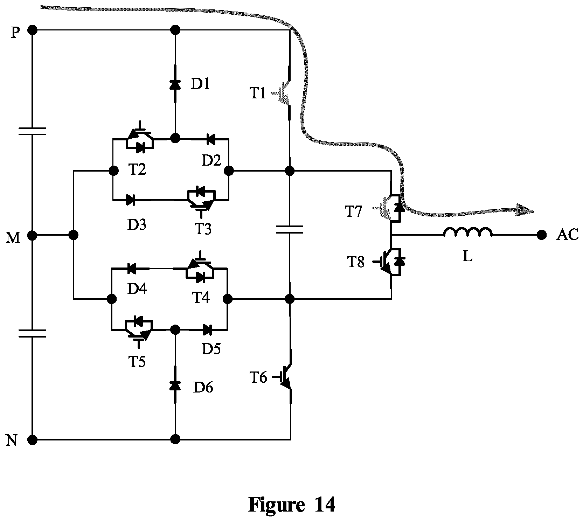

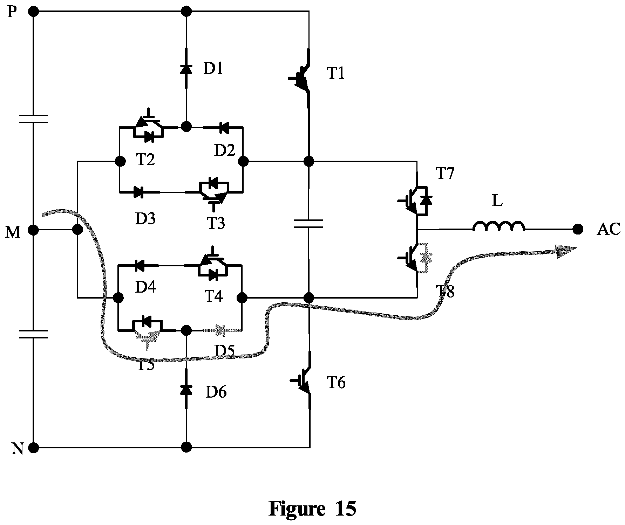

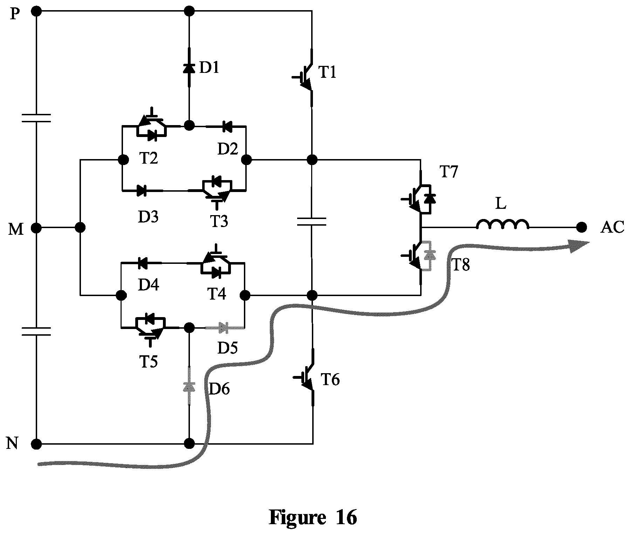

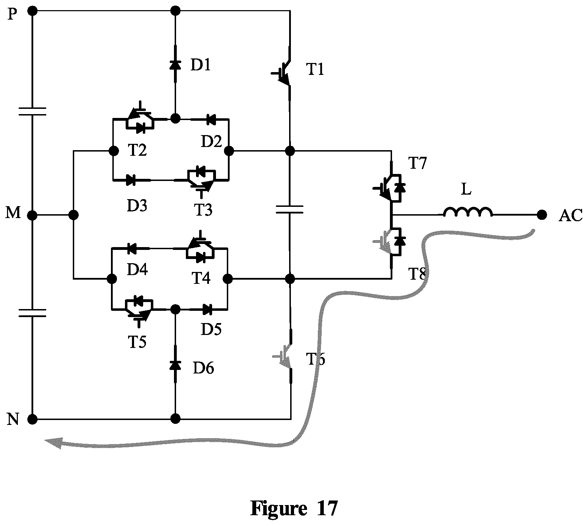

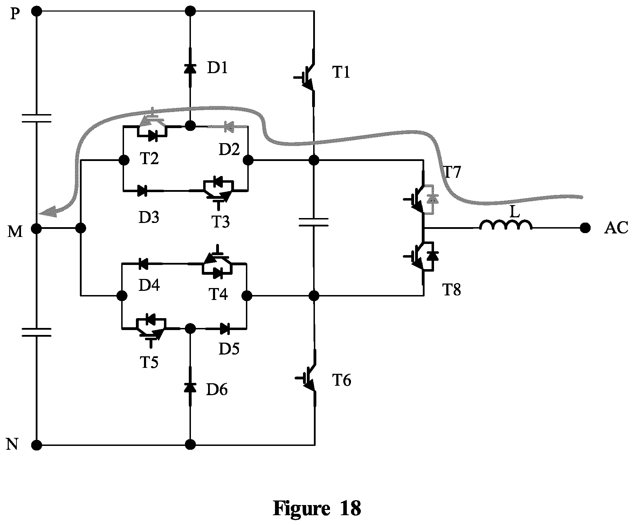

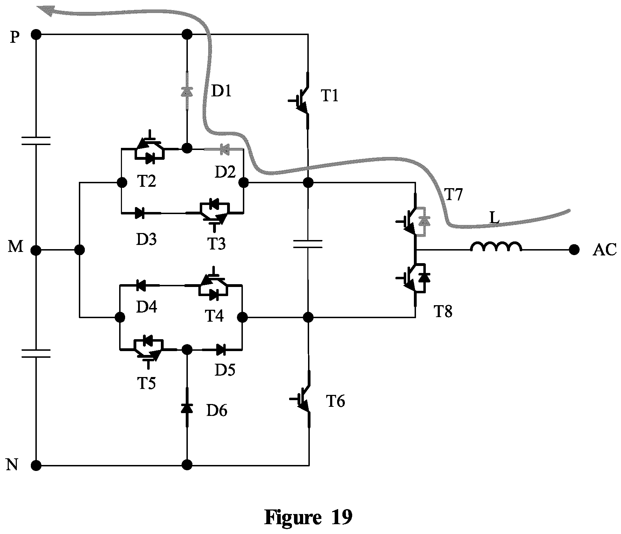

Figures 14 to 16 show the case that a five-level ANPC topology operates in a positive half cycle of the grid voltage, and Figures 17 to 19 show the case that the five-level ANPC topology operates in the negative half cycle of the grid voltage. Similarly, the current path in the power conversion topology of the overcurrent phase is controlled to go through all three figures in each case, while the current path in the power conversion topology of the non-overcurrent phase is controlled to go through merely first two of the three figures in each case. The principle thereof is similar to that in the above scenarios, and thus is not described in detail.

In practice, in order to implement the above step (1), a non-freewheeling switching transistor in the power conversion topology of the overcurrent phase may be first turned off, and a freewheeling switching transistor in the power conversion topology of the overcurrent phase is turned off if a first preset delay expires. As described above, the freewheeling switching transistor is a switching transistor forming a zero-level path in the power conversion topology, and the non-freewheeling switching transistor is a switching transistor in the power conversion topology other than the freewheeling switching transistor.

That is, after obtaining the abnormal signal, the controller applies a first PWM modifying strategy to the overcurrent phase by first turning off the non-freewheeling switching transistors (such as T1 and T4 as shown in Figure 1 or Figure 3, or T1 and T6 as shown in Figure 4), and then turning off the freewheeling switching transistors (such as T2, T3, T5 and T6 as shown in Figure 1, T2 and T3 as shown in Figure 3, or T2 to T5, T7 and T8 as shown in Figure 4) if a preset delay (i.e., the above-described first preset delay) expires.

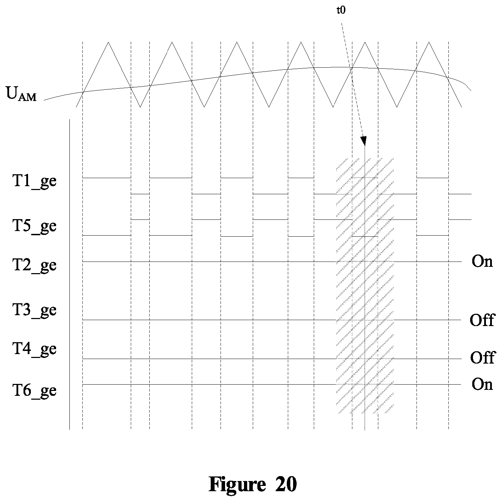

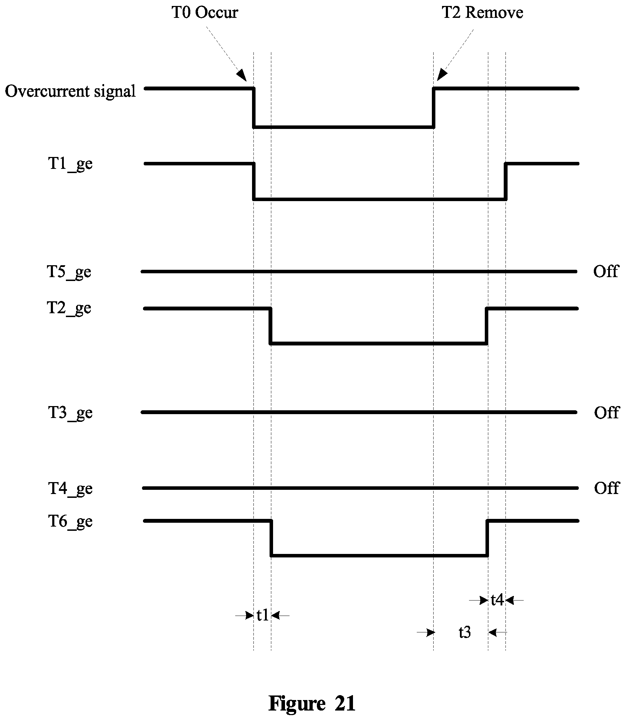

Figure 20 shows a normal PWM control manner of the power conversion topology in the main circuit, i.e., the original PWM control manner applied to the power conversion topology of the overcurrent phase before the overcurrent occurs, taking the three-level ANPC topology operating in the positive half cycle of the grid voltage for example. With reference to Figure 20, when overcurrent is detected at a time instant t0 during normal PWM control, and the PWM control manner is modified according to the above technical solutions, control signals for switching transistors in the power conversion topology of the overcurrent phase change as shown in Figure 21, where an overcurrent signal for any phase being a low level indicates occurrence of an abnormal signal. Waveforms represented by T1_ge to T6_ge indicate change of the control signals for the switching transistors in the power conversion topology of the overcurrent phase. At the time instant t0, the non-freewheeling switching transistor T1 is turned off first, and the current path transits from the arrowed curve shown in Figure 8 to arrowed curve shown in Figure 9. If a first preset delay t1 expires, freewheeling switching transistors T2 and T6, which are previously in turned-on state, are also turned off. Since a direction of the current iL on the filtering inductor L does not change suddenly, the current flows through diodes D3 and D4, and the current path transits from the arrowed curve shown in Figure 9 to the arrowed curve shown in Figure 10. Thus, by the above process, a voltage at an AC side of a bridge arm of this phase, i.e., the voltage at the AC side of the power conversion topology of the overcurrent phase, can be changed, preventing the current iL at the AC side of the power conversion topology of the overcurrent phase from increasing while rapidly reducing the current iL at the AC side, avoiding frequently triggering wave-by-wave current limiting due to the current iL at the AC side being in the vicinity of an overcurrent point. The first preset delay t1 is a duration for which the positive level transits to the zero level, and is used to ensure smooth transition of the voltage at the AC side of the power conversion topology of the overcurrent phase, avoiding overstress on switching transistors. The value of the first preset delay may be determined according to an actual application scenario, and is not specifically limited. As long as the first preset delay is greater than 0.

In practice, in order to implement the above step (2), a non-freewheeling switching transistor in the power conversion topology of the non-overcurrent phase is turned off, and an original control signal for a freewheeling switching transistor in the power conversion topology of the non-overcurrent phase may be maintained.

That is, after obtaining the abnormal signal, the controller applies a second PWM modifying strategy to the non-overcurrent phase by turning off the non-freewheeling switching transistors (such as T1 and T4 as shown in Figure 1 or Figure 3, or T1 and T6 as shown in Figure 4), and maintaining the original control signal for the freewheeling switching transistors (such as T2, T3, T5 and T6 as shown in Figure 1, T2 and T3 as shown in Figure 3, or T2 to T5, T7 and T8 as shown in Figure 4).

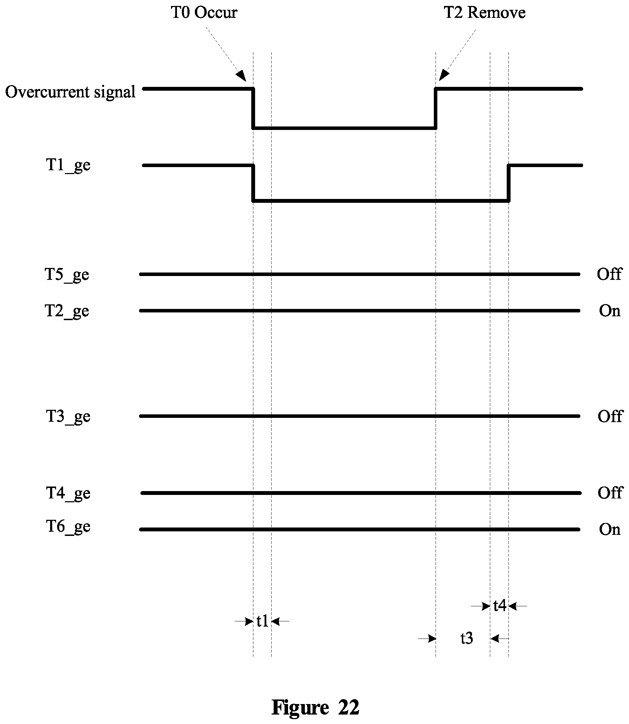

Reference may be made to Figure 22 for the power conversion topology of the non-overcurrent phase. The waveforms represented by T1_ge to T6_ge indicate changes of the control signals for the switching transistors in the power conversion topology of the non-overcurrent phase. At the time instant t0, the non-freewheeling switching transistor T1 is turned off, and the current path transits from the arrowed curve shown in Figure 8 to arrowed curve shown in Figure 9. If the first preset delay t1 expires, original control signals for the freewheeling switching transistors T2, T3, T5 and T6 are maintained, that is, freewheeling switching transistors T2 and T6 are maintained on, and freewheeling switching transistors T3 and T5 are maintained off

Turning off the non-freewheeling switching transistors can prevent, in advance, the current at the AC side of the power conversion topology of the non-overcurrent phase from continuing increasing, and maintaining the original control signal for the freewheeling switching transistors can ensure that the current at the AC side of this phase stably decreases, achieving a better balance between currents of the three phases and a small overall output fluctuation.

It is worth noting that, the technical solution of uniformly modifying the power conversion topologies for the three phases in the conventional technology also has the following disadvantages. In the non-overcurrent phase, the switching transistors may have some ineffective switching actions, a frequency of switching actions increases, the number of switching actions of the freewheeling switching transistor increases, resulting in an increase in switching loss of the power converter and a decrease in the efficiency. In addition, the ineffective switching actions change the current path, resulting in a large fluctuation on the currents at the AC sides of the three phases. Furthermore, as a current of the non-overcurrent phase is less than a current of the overcurrent phase, a reverse current may be generated in the non-overcurrent phase caused by the current dropping to zero after the freewheeling switching transistors is turned off, that is, the current path changes again. The reverse current may easily cause a dynamic voltage unbalance between inner switching transistors, and the voltage unbalance between switching transistors may lead to the risk of overvoltage failure.

In the method according to this embodiment, a PWM modifying strategy is applied to the power conversion topology of each phase based on an overcurrent characteristic of the phase, which can not only suppress overcurrent, but also balance the currents at the AC sides of the three phases by the above process if overcurrent occurs, thereby achieving a small overall fluctuation in the currents at the AC sides. In addition, the number of switching actions is reduced, the switching actions of the freewheeling switching transistors are reduced, the switching loss is reduced, and wafer is prevented from transient overheating, which is beneficial to safety of the wafer. Moreover, maintaining the original control signals for the freewheeling switching transistors provides a zero-level clamping path, for example, zero-level paths as shown in Figures 9, 12, 15 and 18. After the current at the AC side of the power conversion topology of the non-overcurrent phase drops to zero, even if the current reverses, the inner switching transistor is free of the risk of electrical overstress due to the presence of the zero-level clamping path.

Based on the above embodiments, in an embodiment, some examples for the specific implementation of step S103 in the above method for controlling a power converter are given. For example, step S103 may include the following steps (1) and (2).

In step (1), the voltage at the AC side of the power conversion topology of the overcurrent phase is controlled to be a zero level.

In practice, a control signal for the freewheeling switching transistor in the power conversion topology of the overcurrent phase is restored to the original control signal, to control the voltage at the AC side of the power conversion topology of the overcurrent phase to be a zero level.

The following description is made taking the three-level ANPC topology operating in the positive half cycle of the grid voltage for example. As shown in Figure 21, freewheeling switching transistors T2 and T6 are first turned back on.

In step (2), voltages at AC sides of the power conversion topologies of the three phases are restored to respective original levels if a second preset delay expires.

In practice, control signals for non-freewheeling switching transistors in the power conversion topologies of the three phases are restored to respective original control signals, to restore the voltages at the AC sides of the power conversion topologies of the three phases to the respective original levels.

The following description is made taking the three-level ANPC topology operating in the positive half cycle of the grid voltage for example. As shown in Figure 21 and Figure 22, the non-freewheeling switching transistor T1 is turned back on if the second preset delay t4 expires from the time when the freewheeling switching transistors T2 and T6 are turned back on.

The second preset delay T4 is a duration for which the zero level transits to the positive level, and may be the same or different from the first preset delay T1. Preferably, the second preset delay T4 may be set to equal to the first preset delay T1, so that symmetric processing can be achieved in software control and therefore a more convenient implementation.

In an example, after the overcurrent is removed, the power conversion topologies of the three phases are restored to be in the original PWM control manner if a third preset delay expires. As shown in Figure 21 and Figure 22, an overcurrent signal is restored to a high level at a time instant t2, indicating that the overcurrent is removed, and step S103 is performed if the third preset delay t3 expires. In practice, the value of the third preset delay t3 may be determined according to an actual application scenario, which may be set as t3≥0 and is not limited herein. The third preset delay t3 greater than 0 can ensure that the current rapidly decreases.

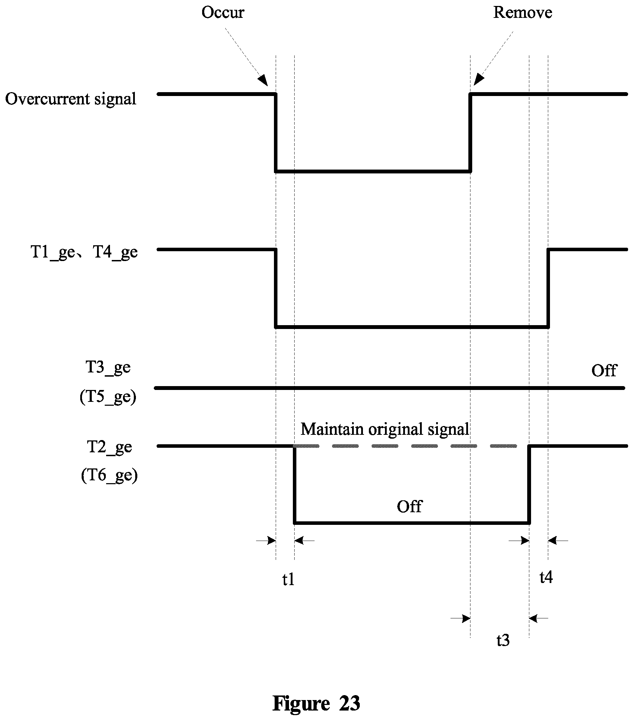

Figure 23 is an exemplary presentation of the power conversion topology shown in Figure 1 and Figure 3 operating in the positive half cycle of the grid voltage. In a case that the power conversion topology is the three-level NPC topology shown in Figure 3, control signals for freewheeling switching transistors in the three-level NPC topology only includes T2_ge and T3_ge; in a case that the power conversion topology is the three-level ANPC topology shown in Figure 1, control signals for freewheeling switching transistors in the three-level ANPC topology further includes T5_ge and T6_ge in the parentheses. In addition, for the clamping switching transistor T2 (or T2 and T6), the solid line in a control signal for the clamping switching transistor T2 represents the situation if the clamping switching transistor T2 is in the power conversion topology of the overcurrent phase, and the dotted line in the control signal represents the situation if the clamping switching transistor T2 is in the power conversion topology of the non-overcurrent phase.

A power converter is further provided according to an embodiment of the present disclosure. As shown in Figure 5, the power converter includes a main circuit 10 and a controller (not shown).

The main circuit 10 includes power conversion topologies 101 of three phases, where DC sides of the power conversion topologies 101 of the three phases are connected in parallel to a DC bus (including a positive electrode P, a negative electrode N and a middle point M), AC sides of the power conversion topologies of the three phases serve as an AC side of the main circuit 10. The power conversion topologies 101 of the three phases may be configured for inversion or rectification, which is not limited herein.

The power conversion topology 101 is a multi-level topology, such as an ANPC topology with three levels or more than three levels (for example, the three-level ANPC topology as shown in Figure 1 or the five-level ANPC topology as shown in Figure 4), an NPC topology with three levels or more than three levels (for example, the three-level NPC topology as shown in Figure 3), or a flying capacitor topology with three levels or more than three levels. The multi-level topology is not limited herein, and may be determined according to an actual application scenario. All implementations fall within the protection scope of the present disclosure.

In practice, the main circuit may further include at least one preceding-stage conversion circuit, where the at least one preceding-stage conversion circuit is connected to the DC bus and is controlled by the controller. The at least one preceding-stage conversion circuit is a DC/DC conversion circuit or an AC/DC conversion circuit. Reference may be made to conventional technology for a specific structure and operation principle thereof, which is not described herein in detail.

Reference may be made to conventional technology for other structures in the main circuit of the power converter, which is not described herein in detail. Depending on the structure of the main circuit, the power converter may be a grid-connected inverter, an off-grid inverter, an energy storage converter or a wind power converter, which is not limited herein.

The main circuit 10 is controlled by the controller, and the controller is configured to perform the method for controlling a power converter according to any one of the foregoing embodiments. Reference can be made to the foregoing embodiments for a specific process and principle of the method, which is not described herein in detail.

The controller performs the above method to change the current path in the power conversion topology of the overcurrent phase and rapidly prevent the current at the AC side from increasing, effectively solving the problem of overcurrent caused by the influence of outside disturbance on the power converter and ensuring stable operation of the power converter. Furthermore, if overcurrent occurs, the current in the power conversion topology of the non-overcurrent phase is prevented from continuing increasing in advance, achieving a balance between the currents at the AC sides of the three phases, and a small overall fluctuation in the currents at the AC sides. In addition, the number of switching actions is reduced, the switching loss is reduced, and wafer is prevented from transient overheating, which is beneficial to safety of the wafer. Moreover, maintaining the original control signal for the freewheeling switching transistors in the power conversion topology of the non-overcurrent phase provides a zero-level clamping path. After the current at the AC side of the power conversion topology of the non-overcurrent phase drops to zero, even if the current reverses, the inner switching transistor is free of the risk of electrical overstress due to the presence of the zero-level clamping path.

A power conversion system is further provided according to an embodiment of the present disclosure, which includes: a power supply and the power converter according to any one of the foregoing embodiments. The power supply is connected to at least one of a power grid or a load through the power converter.

The power supply may be implemented depending on the structure of the main circuit in the power converter, for example, the power supply may be a photovoltaic string, a battery cluster or a wind turbine, which is not limited herein, and may be determined according to an actual application scenario with reference to conventional technology. All implementations fall within the protection scope of the present disclosure.

In practice, in a case that the main circuit is a two-stage conversion structure, controllers for respective conversion circuits may be integrally provided, so that the power converter is an integral device. Alternatively, the controllers for the respective conversion circuits may be integrated with the respective conversion circuits in separate devices, which may be determined according to an actual application scenario and is not limited herein. In addition, the number of power converters is not limited, as long as the power converters are connected to corresponding power supplies, which shall fall within the protection scope of the present disclosure.

By the power converter, the power conversion system can have the advantages of the above-described power converter, which are not described herein in detail.

Reference may be made to each other of the same and similar parts between the various embodiments in this specification and each embodiment focuses on its differences from other embodiments. In particular, for the system or system embodiments, since they are basically similar to the method embodiments, the description is relatively simple. For relevant details, reference can be made to the description of the method embodiments. The system and system embodiments described above are only illustrative, in which the units described as separate components may or may not be physically separated, and the components shown as units may or may not be physical units, that is, they can be located in one place, or distributed over multiple network elements. Some or all of the modules can be selected according to actual needs to achieve the purpose of the solution of this embodiment. Those skilled in the art can understand and implement the method without any creative effort.

Those skilled in the art may further realize that the units and algorithm steps of each example described in connection with the embodiments disclosed herein can be implemented by electronic hardware, computer software, or a combination of both. In order to clearly illustrate the interchangeability between hardware and software, in the above description, the composition and steps of each example have been generally described according to functions. Whether these functions are performed in hardware or software form depends on the specific application and design constraints of the technical solution. Those skilled in the art may implement the described functionality using different methods for each specific application, but such implementations should not be considered to be beyond the scope of the present disclosure.

With regard to the above description of the disclosed embodiments, the features described in the embodiments in this specification can be replaced or combined with each other to enable those skilled in the art to implement or use the present disclosure. Various modifications to these embodiments will be readily apparent to those skilled in the art, and the generic principles defined herein may be practiced in other embodiments without departing from the scope of the disclosure. Thus, the present disclosure is not limited to the embodiments shown herein but is to be accorded the widest scope consistent with the principles and novel features disclosed herein.

**Claims**

1. A method for controlling a power converter, wherein a main circuit of the power converter comprises power conversion topologies of three phases, each of the power conversion topologies is a multi-level topology, and the method comprises:

   detecting a current of the main circuit;
   applying a plurality of pulse width modulation, PWM, modifying strategies to the power conversion topologies of the three phases if overcurrent occurs in the main circuit, wherein among the plurality of PWM modifying strategies, a change range of a voltage at an alternating current, AC, side of a power conversion topology of an overcurrent phase is greater than a change range of a voltage at an AC side of a power conversion topology of a non-overcurrent phase, and a decrease speed of a current at the AC side of the power conversion topology of the overcurrent phase is greater than a decrease speed of a current at the AC side of the power conversion topology of the non-overcurrent phase; and
   restoring, after the overcurrent is removed, the power conversion topologies of the three phases to be in an original PWM control manner.

2. The method for controlling a power converter according to claim 1, wherein the applying a plurality of PWM modifying strategies to the power conversion topologies of the three phases comprises:

   controlling the voltage at the AC side of the power conversion topology of the overcurrent phase to change from a current level to a reverse level after passing through a zero level; and
   controlling the voltage at the AC side of the power conversion topology of the non-overcurrent phase to change from a current level to the zero level.

3. The method for controlling a power converter according to claim 2, wherein the controlling the voltage at the AC side of the power conversion topology of the overcurrent phase to change from a current level to a reverse level after passing through a zero level comprises:

turning off a non-freewheeling switching transistor in the power conversion topology of the overcurrent phase; and turning off a freewheeling switching transistor in the power conversion topology of the overcurrent phase if a first preset delay expires, wherein the freewheeling switching transistor is a switching transistor forming a zero-level path in the power conversion topology of the overcurrent phase, and the non-freewheeling switching transistor is a switching transistor in the power conversion topology of the overcurrent phase other than the freewheeling switching transistor.

4.  The method for controlling a power converter according to claim 2, wherein the controlling the voltage at the AC side of the power conversion topology of the non-overcurrent phase to change from a current level to the zero level comprises:
    turning off a non-freewheeling switching transistor in the power conversion topology of the non-overcurrent phase, and maintaining an original control signal for a freewheeling switching transistor in the power conversion topology of the non-overcurrent phase, wherein the freewheeling switching transistor is a switching transistor forming a zero-level path in the power conversion topology of the non-overcurrent phase, and the non-freewheeling switching transistor is a switching transistor in the power conversion topology of the non-overcurrent phase other than the freewheeling switching transistor.

5.  The method for controlling a power converter according to any one of claims 1 to 4, wherein the restoring the power conversion topologies of the three phases to be in an original PWM control manner comprises:

    controlling the voltage at the AC side of the power conversion topology of the overcurrent phase to be a zero level; and
    restoring voltages at AC sides of the power conversion topologies of the three phases to respective original levels if a second preset delay expires.

6.  The method for controlling a power converter according to claim 5, wherein the controlling the voltage at the AC side of the power conversion topology of the overcurrent phase to be a zero level comprises:
    restoring a control signal for a freewheeling switching transistor in the power conversion topology of the overcurrent phase to an original control signal, wherein the freewheeling switching transistor is a switching transistor forming a zero-level path in the power conversion topology of the overcurrent phase.

7.  The method for controlling a power converter according to claim 5, wherein the restoring voltages at AC sides of the power conversion topologies of the three phases to respective original levels comprises:
    restoring control signals for non-freewheeling switching transistors in the power conversion topologies of the three phases to respective original control signals, wherein the non-freewheeling switching transistors are switching transistors in the power conversion topologies of the three phases other than freewheeling switching transistors, and the freewheeling switching transistors are switching transistors forming a zero-level path in the power conversion topologies.

8.  The method for controlling a power converter according to claim 5, wherein the second preset delay is equal to or different from the first preset delay.

9.  The method for controlling a power converter according to any one of claims 1 to 4, wherein the restoring after the overcurrent is removed, the power conversion topologies of the three phases to be in an original PWM control manner further comprises:
    restoring the power conversion topologies of the three phases to be in the original PWM control manner if a third preset delay expires.

10. A power converter, comprising

    a main circuit; and
    a controller,
    wherein the main circuit comprises power conversion topologies of three phases, direct current, DC, sides of the power conversion topologies of the three phases are connected in parallel to a DC bus, and alternating current, AC, sides of the power conversion topologies of the three phases serve as an AC side of the main circuit,

each of the power conversion topologies is a multi-level topology,

the main circuit is controlled by the controller, and

the controller is configured to perform the method for controlling a power converter according to any one of claims 1 to 9.

11. The power converter according to claim 10, wherein the multi-level topology is one of the following topologies: an active neutral point clamped, ANPC, topology with three levels or more than three levels, a neutral point clamped, NPC, topology with three levels or more than three levels, or a flying-capacitor topology with three levels or more than three levels.

12. The power converter according to claim 10 or 11, wherein the main circuit further comprises at least one preceding-stage conversion circuit,

wherein the at least one preceding-stage conversion circuit is connected to the DC bus and is controlled by the controller.

13. The power converter according to claim 12, wherein the at least one preceding-stage conversion circuit is a DC/DC conversion circuit or an AC/DC conversion circuit.

14. A power conversion system, comprising:

a power supply; and

the power converter according to any one of claims 10 to 13,

wherein the power supply is connected to at least one of a power grid or a load through the power converter.

**Figure 1**

**Figure 2**

Figure 3

Figure 4

P

101

101

101

10

M

Power
conversion
topology

on

on

N

Figure 5

**Figure 6**

**Figure 7**

**Figure 8**

**Figure 9**

**Figure 10**

**Figure 11**

**Figure 12**

**Figure 13**

**Figure 14**

**Figure 15**

**Figure 16**

**Figure 17**

Figure 18

**Figure 19**

**Figure 20**

Figure 21

**Figure 22**

Figure 23

Europäisches
Patentamt

European
Patent Office

Office européen
des brevets

# EUROPEAN SEARCH REPORT

**Application Number**

EP 24 20 1855

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 913 784 A1 (SHENZHEN KSTAR SCIENCE AND TECH CO LTD [CN]) 24 November 2021 (2021-11-24) * abstract * * paragraph [0001] - paragraph [0193]; figures 1-25e * | 1-14 | INV. H02M1/32 H02M7/487 |
| A | EP 3 154 181 A1 (SUNGROW POWER SUPPLY CO LTD [CN]) 12 April 2017 (2017-04-12) * abstract * * figure 4 * | 1-14 | |

TECHNICAL FIELDS
SEARCHED     (IPC)

H02M

The present search report has been drawn up for all claims

| Place of search | Date of completion of the search | Examiner |
|---|---|---|
| The Hague | 17 February 2025 | Adami, Salah-Eddine |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 24 20 1855

This annex lists the patent family members relating to the patent documents cited in the above-mentioned European search report.
The members are as contained in the European Patent Office EDP file on
The European Patent Office is in no way liable for these particulars which are merely given for the purpose of information.

17-02-2025

| Patent document cited in search report | | Publication date | Patent family member(s) | | Publication date |
|---|---|---|---|---|---|
| EP 3913784 | A1 | 24-11-2021 | CN | 111478609 A | 31-07-2020 |
| | | | EP | 3913784 A1 | 24-11-2021 |
| | | | US | 2021367530 A1 | 25-11-2021 |
| EP 3154181 | A1 | 12-04-2017 | AU | 2016234982 A1 | 27-04-2017 |
| | | | CA | 2942254 A1 | 10-04-2017 |
| | | | CN | 105226978 A | 06-01-2016 |
| | | | EP | 3154181 A1 | 12-04-2017 |
| | | | JP | 6543864 B2 | 17-07-2019 |
| | | | JP | 2017077163 A | 20-04-2017 |
| | | | US | 2017104424 A1 | 13-04-2017 |

EPO FORM P0459

For more details about this annex : see Official Journal of the European Patent Office, No. 12/82